# EUROPEAN PATENT SPECIFICATION

(11) **EP 2 770 542 B1**
(45) Date of publication and mention of the grant of the patent: **02.01.2019**
(21) Application number: 12876498.2
(22) Date of filing: 20.09.2012
(51) Int. Cl.: H01L 31/054, H01L 31/052, H02S 10/30

(54) **SOLAR ENERGY GENERATING SYSTEM FOR HIGH TEMPERATURE ENVIRONMENTS**
SYSTEM ZUR GEWINNUNG VON SONNENENERGIE FÜR HOCHTEMPERATURUMGEBUNGEN
SYSTÈME DE GÉNÉRATION D'ÉNERGIE SOLAIRE POUR ENVIRONNEMENTS À HAUTE TEMPÉRATURE

(30) Priority: 10.05.2012 KR 20120049623
(43) Date of publication of application: 27.08.2014
(73) Proprietor: Korea Institute Of Machinery & Materials, Yuseong-gu Daejeon 305-343 (KR)
(72) Inventor: HAN, Seung-Woo, Daejeon 305-343 (KR); PARK, Hyun-Sung, Daejeon 305-343 (KR); KIM, Jung Yup, Daejeon 305-343 (KR)
(74) Representative: Meyer-Dulheuer, Karl-Hermann
(86) International application number: PCT/KR2012/007543
(87) International publication number: WO 2013/168855

(56) References cited:
- WO-A1-2012/032462
- WO-A2-2010/147638
- DE-A1-102005 054 364
- JP-A- H1 131 835
- JP-A- H10 238 866
- JP-A- 2003 249 665
- JP-A- 2010 072 549

## Description

### BACKGROUND

### 1. Field of Disclosure

The present disclosure of invention relates to a solar energy generation system. More particularly, the present disclosure of invention relates to a solar energy generation system generating electricity using a solar energy for high temperature environment more efficiently.

### 2. Description of Related Technology

Most of the generation systems using a solar energy is a photovoltaic generation system, and in the photovoltaic generation system, a solar cell including a compound semiconductor like gallium arsenide (GaAs), single crystal silicon, polycrystalline silicon, and so on which may have photovoltaic effect, is used to absorb the solar energy to generate electricity. In the photovoltaic generation system, ultraviolet rays (UV) and visible light having a spectrum range between 200 nm and 800 nm which is about 58% of total solar energy, are used, but infrared light having a spectrum range between 800 nm and 3,000 nm which is about 42% of total solar energy is not used.

In addition, efficiency of the solar energy is decreased in a high temperature, and thus for high temperature environment like Southeast Asia and Africa, the solar energy is less generated and additional equipments are necessary for cooling the solar cell.

Accordingly, a hybrid generation system is required to use infrared light in addition to the generation using ultraviolet rays and visible light, and a solar energy generation system is required to prevent the efficiency of the solar cell from being decreased to generate the electricity. In this regards, MATSUBAYASHI MASAYUKI (JP H11 31835 A) discloses a solar thermal power generation system to enhance the solar heat utilization efficiency significantly by arranging a wavelength selection reflecting/transmitting film on the surface of a solar cell and arranging a thermoelectric power generation element and a heat exchanger oppositely to the solar cell.

### SUMMARY

The present invention is developed to solve the above-mentioned problems of the related arts. An example not being part of the invention provides a solar energy generation system for high temperature environment capable of filtering a solar energy in a spectrum range suitable for a photovoltaic generation and providing the filtered solar energy to a solar cell.

The present invention, as defined in the independent claim, provides a solar energy generation system for high temperature environment having a lens part reflecting the solar energy in the spectrum range suitable for the photovoltaic generation to a photovoltaic generation part, and transmitting a solar energy in a spectrum range unsuitable for the photovoltaic generation to a thermoelectric generation part.

In addition, the present invention also provides a solar energy generation system for high temperature environment having a filter coated on a solar energy incident surface of a lens part, reflecting a specific range of spectrum and transmitting a remaining range of the spectrum.

According to an example not being part of the invention, a solar energy generation system for high temperature environment includes a solar cell and a first filter. The solar cell is disposed for photovoltaic generation. The first filter is disposed on an incident surface of the solar cell, transmits a first solar energy of an incident solar energy having a first spectrum range suitable for photovoltaic generation to the solar cell, and reflects a second solar energy having a second spectrum range except for the first spectrum range of the incident solar energy.

In an example, the first filter may be a band pass filter, through which the first solar energy having the first spectrum range between 200 nm and 800 nm is transmitted and the second solar energy having the second spectrum range between 800 nm and 3,000 nm is reflected.

According to the invention, a solar energy generation system for high temperature environment includes a solar cell, a thermoelectric module unit and a lens part. The solar cell is disposed for photovoltaic generation. The thermoelectric module unit is disposed for thermoelectric generation. The lens part includes a second filter and a lens. The second filter reflects a first solar energy an incident solar energy having a first spectrum range suitable for photovoltaic generation to the solar cell. The lens collects a second solar energy having a second spectrum range except for the first spectrum range of the incident solar energy to the thermoelectric module unit. A condensing surface of the solar cell faces an incident surface of the lens part, and a collecting surface of the thermoelectric module unit faces a transmitting surface of the lens part.

In an embodiment, the second filter may be coated on the incident surface of the lens.

In an example, the second filter may be a band pass filter, through which the first solar energy having the first spectrum range between 200 nm and 800 nm is reflected and the second solar energy having the second spectrum range between 800 nm and 3,000 nm is transmitted.

In an embodiment, the thermoelectric module unit includes an absorbing plate, a cooling plate and a thermoelectric module. The absorbing plate has a first surface on which the collecting surface for the second solar energy is disposed. The cooling plate is spaced apart from a second surface of the absorbing plate by a predetermined distance and have a cooling unit. The thermoelectric module is disposed between the absorbing plate and the cooling plate.

In the invention, the collecting surface of the absorbing plate is protruded into an incident direction of the second solar energy, to uniformly distribute the incident second solar energy on the second surface.

According to the example embodiments, the solar energy in the spectrum range suitable for the photovoltaic generation is separately condensed in the solar cell for effectively cooling the solar cell, and thus the solar cell may be generated more efficiently for high temperature environment.

In addition, the incident solar energy is reflected and transmitted to be separated into a solar energy in the specific spectrum range suitable for the photovoltaic generation and a solar energy in the remaining spectrum range suitable for the thermoelectric generation, and thus the solar energy may be generated more efficiently.

### BRIEF DESCRIPTION OF THE DRAWINGS

The above and other features and advantages will become more apparent by describing example embodiments thereof with reference to the accompanying drawings, in which:
FIG. 1 is a front view illustrating a solar energy generation system according to an example not being part of the present invention;
FIG. 2 is a front view illustrating a solar energy generation system according to the present invention;
FIG. 3 is a perspective view illustrating the solar energy generation system in FIG. 2; and
FIG. 4 is a front view illustrating a thermoelectric module unit of the solar energy generation system in FIG. 2.

### DETAILED DESCRIPTION

Hereinafter, example embodiment of the invention will be explained in detail with reference to the accompanying drawings.

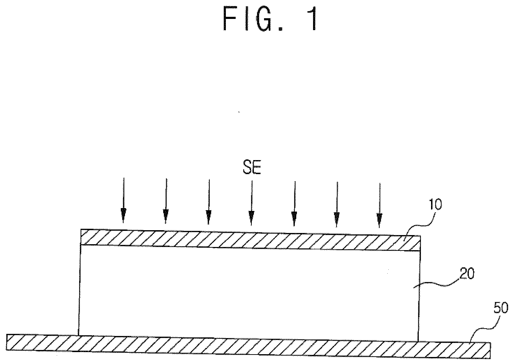

FIG. 1 is a front view illustrating a solar energy generation system according to an example not being part of the present invention.

Referring to FIG. 1, the solar energy generation system includes a first filter 10, a solar cell 20 and a housing 50.

The housing 50 has a plate shape, and fixes and supports the solar cell 20. Alternatively, the housing 50 may have various shapes for fixing and supporting the solar cell 20, and the housing 50 and the solar cell 20 may be combined with each other conventionally. The solar cell 20 is disposed on the housing 50, and condenses a solar energy for photovoltaic generation, and thus the conventional solar cell may be used.

The first filter 10 is disposed on an incident surface of the solar cell 20. For example, the first filter 10 may be coated on the incident surface of the solar cell 20. The first filter 10 transmits ultraviolet rays (UV) and visible light having a first spectrum range between 200 nm and 800 nm suitable for photovoltaic generation of an incident solar energy SE, and reflects infrared light having a second spectrum range except for the first spectrum range. The first filter 10 may be a conventional band pass filter having a multi layer selectively transmitting ultraviolet rays (UV) and visible light having the first spectrum range between 200 nm and 800 nm.

Accordingly, the solar energy may be selectively transmitted through the first filter 10, and thus temperature of the solar cell 20 may be prevented from being increased and the solar cell 20 may be effectively operated. For example, in high temperature environment like Southeast Asia and Africa, the solar cell may be effectively operated without being decreased in its generation efficiency.

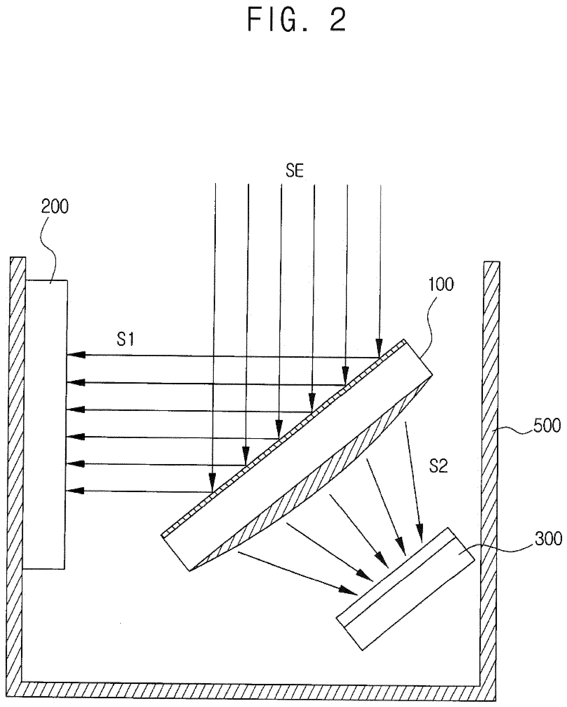

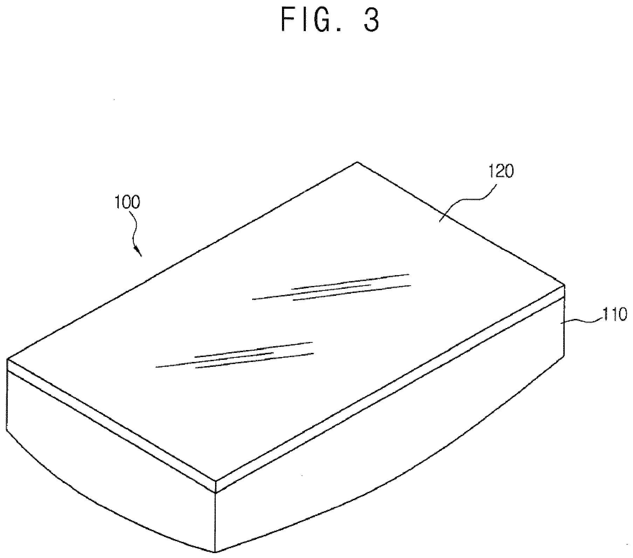

FIG. 2 is a front view illustrating a solar energy generation system according to the present invention. FIG. 3 is a perspective view illustrating the solar energy generation system in FIG. 2.

Referring to FIGS. 2 and 3, the solar energy generation system according to the present example embodiment includes a lens part 100, a solar cell 200, a thermoelectric module unit 300 and a housing 500.

Ultraviolet rays and visible light having a first spectrum range between 200 nm and 800 nm suitable for photovoltaic generation of a solar energy is defined as a first solar energy S1, and infrared light having a second spectrum range between 800 nm and 3,000 nm suitable for thermoelectric generation except for the first spectrum range is defined as a second solar energy S2.

The housing 500 has a receiving space in which the lens part 100, the solar cell 200 and the thermoelectric module unit 300 are received. An upper portion of the housing 500 is open and thus the solar energy SE is incident into the housing 500. In the present example embodiment, the upper portion of the housing 500 is open, but alternatively, the upper portion of the housing 500 is closed with a transparent plate through which the solar energy SE is incident.

The lens part 100 is received by the housing 500. An incident surface into which the solar energy SE is incident is formed on a first surface of the lens part 100, and a transmitting surface through which the solar energy SE is transmitted is formed on a second surface of the lens part 100. The second surface is opposite to the first surface.

As illustrated in FIG. 3, the lens part 100 includes a filter 120 and a lens 110. The filter 120 separates the solar energy SE into a solar light S1 and a solar light S2. The lens 110 collects the solar light S2 separated by the filter 120.

The lens part 100 has a rectangular shape as illustrated in FIG. 3. Alternatively, the lens part 100 may have various shapes like a circular shape, a polygonal shape, an elliptical shape and so on, to reflect or transmit the solar energy SE.

The lens 110 may include a transparent material and thus the solar energy SE may be transmitted. The filter 120 is formed on the incident surface of the lens 110. For example, the filter 120 may be coated on the incident surface of the lens 110.

The filter 120 separates the solar energy SE into the first and second solar energies S1 and S2. The filter 120 reflects the first solar energy S1 and transmits the second solar energy S2.

For example, the filter 120 separates ultraviolet rays and visible light having the first spectrum range between 200 nm and 800 nm from the solar energy SE and reflects the ultraviolet rays and visible light, and separates infrared light having the second spectrum range from the solar energy SE and transmits the infrared light. Thus, the filter 120 may be a conventional band pass filter having a multi layer reflecting the specific spectrum range of the solar energy SE.

A surface of the lens 110 opposite to the filter 120 may have a protruded shape like a conventional convex lens, and thus the second solar energy S2 transmitted through the filter 120 is collected to an outer portion of the transmitting surface. Although not shown in the figure, the protruded shape may be like a multi-focused lens or a Fresnel lens.

As illustrated in FIG. 2, the lens part 100 is inclined with respect to an incident direction of the solar energy SE incident into the housing 500 by about 45°. Alternatively, the lens part 100 may be variously disposed in the housing 500, considering the shape of the housing 500, and the positions of the solar cell 200 and the thermoelectric module unit 300.

Accordingly, the lens part 100 separates the solar energy SE incident into an entire area of the lens part 100 into the first solar energy S1 and the second solar energy S2, and respectively provides the first solar energy S1 and the second solar energy S2 to the solar cell 200 and the thermoelectric module unit 300, and thus the generation efficiency may be more increased. In addition, the mal-function or inefficient operation due to increasing temperate may be prevented, because the first solar energy S1 is separated and provided to the solar cell 200. For example, especially in high temperature environment, the solar energy generation system may be more efficiently operated.

The solar cell 200 is received in the housing 500, and the conventional solar cell condensing a solar light for the photovoltaic generation may be applied. In the present example embodiment, a condensing surface of the solar cell 200 faces an incident surface of the lens part 100 which is the filter 120, and thus the solar light reflected by the filter 120 of the lens part 100 may be condensed. Although a single solar cell 200 is disposed in the housing 500 in FIG. 2, a plurality of solar cells may be disposed in the housing 500 as a module considering a size of the lens part 100 and an area of the reflected first solar energy S1.

The thermoelectric module unit 300 is received in the housing 500. Inside of the housing 500, a collecting surface 311 of the thermoelectric module unit 300 faces the lens 110 which is a transmitting surface of the lens part 100, and thus a solar light transmitted through the lens 110 of the lens part 100 may be collected. Although a single thermoelectric module unit 300 is disposed in the housing 500 in FIG. 2, a plurality of thermoelectric module unit 300 may be disposed in the housing 500 with a plurality of rows and columns considering a size of the lens part 100 and an end shape of the lens 110.

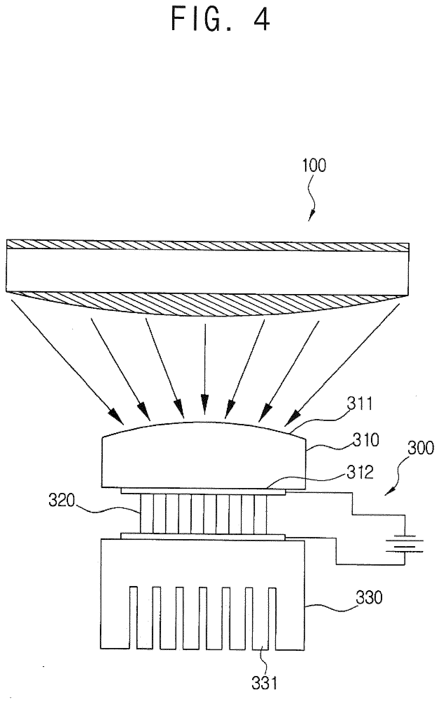

FIG. 4 is a front view illustrating a thermoelectric module unit of the solar energy generation system in FIG. 2.

Referring to FIG. 4, the thermoelectric module unit 300 includes an absorbing plate 310, a thermoelectric module 320 and a cooling plate 330. The thermoelectric module 320 may be a conventional thermoelectric module in which electricity may be generated due to a difference of temperature between the absorbing plate 310 and the cooling plate 330, and thus any detailed explanation concerning the thermoelectric module may be omitted.

The absorbing plate 310 has a plate shape. A collecting plate 311 collecting a solar light of the second solar energy S2 is formed on a first surface of the absorbing plate 310, and a heat dissipating plate 312 transmitting the solar light to the thermoelectric module 320 is formed on a second surface of the absorbing plate 310.

In the present example embodiment, the second solar energy S2 collected to the collecting plate 311 should be distributed to an entire area of the heat dissipating plate 312.

An intensity of the second solar energy S2 is maximum at a central portion of the collecting plate 311, and is decreased as far from the central portion of the collecting plate 311. Thus, in the present example embodiment, a thickness of the absorbing plate 310 is changed to uniformly distribute the second solar energy S2 to an entire area of the heat dissipating plate 312. According to the invention, the thickness of the absorbing plate 310 is increased at the central portion thereof and thus the second solar energy S2 is slowly transmitted, but the thickness of the absorbing plate 310 is decreased as far from the central portion thereof and thus the second solar energy S2 is fast transmitted. Thus, the intensity of the second solar energy S2 is uniformly transmitted in an entire area of the heat dissipating plate 312.

For example, the collecting plate 311 may be protruded toward the lens part 100 like a convex lens at a central portion of the absorbing plate 310. Thus, the collecting plate 311 has a convex shape and the heat dissipating plate 312 has a plain shape, and thus the thickness of the absorbing plate 310 is changed.

The cooling plate 330 is spaced apart from the heat dissipating plate 312 by a predetermined distance, and has a cooling unit 331 to maximize a difference of temperature between the cooling plate 330 and the absorbing plate 310. The cooling unit 331 may be a plurality of heat dissipating pins to increase a heat dissipating area. Although an air cooling type heat dissipating pin is illustrated in FIG. 4, a water cooling type heat dissipating pin may be applied.

According to the present example embodiment, infrared light may also be used for the solar energy generation, and thus efficiency of the solar energy generation may be increased by about 2% due to the thermoelectric generation compared to the efficiency of the solar energy generation merely using the photovoltaic generation, which is conventionally about 15.6%.

In addition, efficiency of the solar cell is not decreased due to the light separation and thus efficiency of the solar energy generation using the photovoltaic generation is additionally increased by about 1.7%.

Further, the solar energy generation system according to the present example embodiment may be used in high temperature environment like Southeast Asia and Africa without decreasing the efficiency of the solar energy generation.

According to the example embodiments, the solar energy in the spectrum range suitable for the photovoltaic generation is separately condensed in the solar cell for effectively cooling the solar cell, and thus the solar cell may be generated more efficiently for high temperature environment.

In addition, the incident solar energy is reflected and transmitted to be separated into a solar energy in the specific spectrum range suitable for the photovoltaic generation and a solar energy in the remaining spectrum range suitable for the thermoelectric generation, and thus the solar energy may be generated more efficiently.

The foregoing is illustrative of the present teachings and is not to be construed as limiting thereof. Although a few example embodiments have been described, those skilled in the art will readily appreciate from the foregoing that many modifications are possible in the example embodiments without departing from the scope of the claims.

## Claims

1. A solar energy generation system comprising:
a solar cell (20) for photovoltaic generation;
a thermoelectric module unit (300) for thermoelectric generation; and
a lens part (100) including a filter (10) and a lens (110), the filter (10) reflecting a first solar energy an incident solar energy having a first spectrum range suitable for photovoltaic generation to the solar cell (20), the lens (110) collecting a second solar energy having a second spectrum range except for the first spectrum range of the incident solar energy to the thermoelectric module unit (300),
wherein a collecting surface of the solar cell (20) faces an incident surface of the lens part (100), and a collecting surface (311) of the thermoelectric module unit (300) faces a transmitting surface of the lens part (100),
wherein the filter (10) is coated on the incident surface of the lens (110),
wherein the thermoelectric module unit (300) comprises an absorbing plate (310) having a first surface on which the collecting surface (311) for the second solar energy is disposed,
**characterized in that**
said first surface is protruded into an incident direction of the second solar energy, to uniformly distribute the incident second solar energy on a second surface opposite to the first surface, wherein the thickness of said absorbing plate (310) is increased at the central portion thereof and decreased further away from said central portion.

2. The solar energy generation system of claim 2, wherein the thermoelectric module unit (300) further comprises:
a cooling plate (330) spaced apart from the second surface of the absorbing plate (310) by a predetermined distance and having a cooling unit (331); and
a thermoelectric module (320) disposed between the absorbing plate (310) and the cooling plate (330).

## Patentansprüche

1. Ein Solarenergiesystem umfassend
eine Solarzelle (20) zur photovoltaischen Stromerzeugung;
ein thermoelektrisches Modul (300) zur thermoelektrischen Stromerzeugung; und
ein Linsenteil (100) beinhaltend einen Filter (10) und eine Linse (110), wobei der Filter (10) eine erste Solarenergiemenge reflektiert, wobei eine einfallende Sonnenstrahlung einen ersten Spektralbereich geeignet für die photovoltaische Stromerzeugung durch die Solarzelle (20) hat, und die Linse (110) eine zweite Solarenergiemenge mit einem zweitem Spektralbereich ausgeschnitten aus dem ersten Spektralbereich der einfallenden Sonnenstrahlung zum thermoelektrischem Modul (300) hin bündelt,
wobei eine Sammlerfläche der Solarzelle (20) einer Einfallfläche the Linsenteils (100) gegenübersteht, und eine Sammlerfläche (311) des thermoelektrischen Moduls (300) einer Übertragungsfläche the Linsenteils (100) gegenübersteht,
wobei der Filter (10) auf der Einfallfläche der Linse (110) beschichtet ist, wobei das thermoelektrische Modul (300) eine Absorberplatte (310) umfasst, die eine erste Oberfläche besitzt auf welcher die Sammleroberfläche (311) für die zweite Solarenergiemenge aufgebracht ist,
charakterisiert dadurch, dass die besagte erste Oberfläche in eine Einfallsrichtung der zweiten Solarengeriemenge ausgewölbt ist, um die einfallende zweite Solarenergiemenge auf einer zweiten Oberfläche, die der ersten Oberfläche gegenübersteht, einheitlich zu verteilen, wobei die Dicke der besagten Absorberplatte (310) in deren zentralen Bereich grösser und vermindert weiter entfernt von besagtem zentralem Bereich ist.

2. Das Solarenergiesystem nach Anspruch 2, wobei das thermoelektrische Modul (300) weiter umfasst:
Eine Kühlplatte (330) abgesetzt in einem vorbestimmten Abstand von der zweiten Oberfläche der Absorberplatte (310), mit einer Kühleinheit (331); und ein thermoelektrisches Modul (320) angebracht zwischen der Absorberplatte (310) und einer Kühlplatte (330).

## Revendications

1. Un système d'énergie solaire comprenant
une cellule solaire (20) pour la production d'énergie photovoltaïque ;
un module thermoélectrique (300) pour la production d'énergie thermoélectrique ; et
une partie de lentille (100) comprenant un filtre (10) et une lentille optique (110), le filtre (10) réfléchissant une première quantité d'énergie solaire, un rayonnement solaire incident ayant une première région spectrale appropriée pour la production d'énergie photovoltaïque par la cellule solaire (20),et la lentille (110) regroupant une seconde quantité d'énergie solaire ayant une seconde région spectrale découpée dans la première région spectrale du rayonnement solaire incident vers le module thermoélectrique (300),
dans laquelle une surface de collecteur de la cellule solaire (20) fait face à une surface incidente de la partie de lentille (100), et une surface de collecteur (311) du module thermoélectrique (300) fait face à une surface de transmission de la partie de lentille (100),
le filtre (10) étant revêtu sur la surface incidente de la lentille (110), le module thermoélectrique (300) comprenant une plaque absorbante (310) ayant une première surface sur laquelle la surface collectrice (311) pour la deuxième quantité d'énergie solaire est appliquée,
**caractérisé en ce que** la plaque absorbante (310) a une première surface sur laquelle la surface collectrice (311) est appliquée, ladite première surface protubérans dans une direction d'incidence de la deuxième quantité d'énergie solaire afin de distribuer uniformément la deuxième quantité d'énergie solaire incidente sur une deuxième surface opposant la première surface, dans laquelle l'épaisseur de ladite plaque absorbante (310) dans sa région centrale est plus grande et réduite plus loin de ladite région centrale.

2. Le système d'énergie solaire selon la revendication 2, le module thermoélectrique (300) comprenant en outre :
une Plaque de refroidissement (330) espacée à une distance prédéterminée de la seconde surface de la plaque absorbante (310), comprenant une unité de refroidissement (331) ; et un module thermoélectrique (320) disposé entre la plaque absorbante (310) et une plaque de refroidissement (330).
